# FASCICULE DE BREVET EUROPEEN

(11) **EP 0 887 234 B1**
(45) Date de publication et mention de la délivrance du brevet: **05.03.2003**
(21) Numéro de dépôt: 98111902.7
(22) Date de dépôt: 26.06.1998
(51) Int. Cl.: B60R 16/02

(54) **Ensemble de commutation de haut de colonne de direction de véhicule automobile et procédé de fabrication d'un tel ensemble**
Kraftfahrzeug-Lenkstockschalteranordnung und Herstellungsverfahren dafür
Steering column stick switch assembly for a vehicle and manufacturing method therefore

(30) Priorité: 27.06.1997 FR 9708098
(43) Date de publication de la demande: 30.12.1998
(73) Titulaire: VALEO ELECTRONIQUE, 94000 Creteil (FR)
(72) Inventeur: Huynh, Tan Duc, 93330 Neuilly Sur Marne (FR)
(74) Mandataire: Gamonal, Didier

(56) Documents cités:
- WO-A-98/42540
- DE-A- 3 111 029
- DE-A- 3 306 285
- DE-A- 3 420 358
- DE-A- 3 522 907
- FR-A- 2 455 531

## Description

La présente invention concerne un ensemble de commutation de haut de colonne de direction de véhicule automobile et un procédé de fabrication d'un tel ensemble.

De tels ensembles sont connus : ils sont, fixés à la colonne de direction et comportent, par exemple, le commutateur d'éclairage et de signalisation et le commutateur de commande d'essuie-vitre et de lave-vitres. L'ensemble de commutation assure la liaison de ces commutateurs par exemple au bus de multiplexage du véhicule.

Dans les ensembles connus, les fonctions électroniques sont réparties dans deux circuits imprimés disposés de part et d'autre de la colonne de direction. En particulier, chaque circuit imprimé assure l'interface avec l'un des commutateurs précités. Il en résulte une multiplicité de certains composants et la fabrication et le montage sont complexes.

On sait par ailleurs que de plus en plus de véhicules automobiles comportent un récepteur radiofréquence pour la télécommande de diverses fonctions, comme par exemple une alarme, le verrouillage-déverrouillage des ouvrants (portières, coffre, trappe pour carburant....) et/ou de l'allumage et/ou de l'alimentation en carburant. Ce récepteur est généralement implanté au niveau de la boîte de fusibles, dans la partie basse de la planche de bord où les obstacles métalliques sont nombreux ; il en résulte une mauvaise réception radioélectrique.

Le document WO 98/42540 A1, formant un état de technique selon l'article 54 (3) et (4) CBE pour les états contractants AT, BE, CH, DE, DK, ES, FR, GB, GR, IE, LI, LU, MC, NL, PT, divulgue un ensemble de commutation de haut de colonne de direction de véhicule automobile. L'ensemble comprend un boîtier, monté sur la colonne de direction pour supporter, au-dessus de ladite colonne, un récepteur radiofréquence de télécommande monté sur une carte de circuit imprimé unique. La carte entoure la colonne de direction en forme de «U».

La présente invention définie par la revendication 1 vise à pallier ces inconvénients.

Selon l'invention, un ensemble de commutation de haut de colonne de direction de véhicule automobile est caractérisé par le fait qu'il comprend des moyens de support pour supporter, au-dessus de la colonne de direction, un récepteur radiofréquence de télécommande et son antenne.

Le récepteur se trouve ainsi implanté en partie haute, en un emplacement où les pièces métalliques de carrosserie se trouvent clairsemées. En outre, la colonne de direction ne fait pas obstacle, puisqu'elle se trouve au-dessous du récepteur. Il en résulte une bien meilleure réception que dans l'art antérieur.

Avantageusement, lesdits moyens de support comprennent une partie de circuit imprimé portée par un boîtier monté sur la colonne de direction.

L'encombrement du récepteur radiofréquence peut ainsi être minimum, et son montage présente une grande simplicité.

De préférence, l'ensemble de commutation comprend une carte de circuit imprimé formant carte mère, traversée par la colonne de direction, électriquement connectée à ladite partie de circuit imprimé, et portant un connecteur de liaison au faisceau électrique du véhicule.

Avantageusement, ladite partie de circuit imprimé est formée dans la partie de la carte mère découpée pour le passage de la colonne de direction et électriquement reliée à la carte mère par une nappe de fils.

On évite ainsi la perte de matière puisque la chute est récupérée pour l'implantation du récepteur.

De préférence, la découpe pour le passage de la colonne de direction est circulaire.

Avantageusement, ladite partie de circuit imprimé est engagée dans des glissières du boîtier.

De préférence, l'antenne est sérigraphiée sur la partie de circuit imprimé.

Avantageusement, le boîtier supporte au moins un commutateur coopérant électriquement avec la carte mère ; le commutateur est un commutateur d'éclairage et signalisation ; le commutateur est un commutateur d'essuie-vitre et lave-vitre.

Cet agencement entraîne une simplification importante de l'électronique, et notamment de la connectique entre les différentes fonctions assurées par l'ensemble de commutation ; de plus, grâce à cette disposition, il est possible de tester électriquement le fonctionnement de l'ensemble de commutation avant son montage sur véhicule, notamment chez le fabricant avant livraison au constructeur de véhicule.

Avantageusement, la télécommande commande une alarme et/ou le verrouillage-deverrouillage des ouvrants et/ou de l'allumage et/ou de l'alimentation en carburant.

L'invention a également pour objet un procédé de réalisation d'un ensemble de commutation tel que ci-dessus ; ledit procédé défini par la revendication 10 est caractérisé par le fait que l'on monte les composants sur un circuit imprimé unique, avec la nappe de fils reliant la partie centrale de ce circuit imprimé unique à sa partie périphérique, et que l'on découpe ensuite la partie centrale.

On décrira maintenant, à titre d'exemple non limitatif, un mode de réalisation particulier de l'invention, en référence aux dessins schématiques annexés dans lesquels:
- la figure 1 est une vue en perspective éclatée d'un ensemble de commutation de haut de colonne de direction de véhicule automobile, réalisé selon la présente invention ;
- la figure 2 est une vue de face de la carte mère de cet ensemble de commande ;
- la figure 3 est une vue en perspective éclatée du commutateur d'éclairage et de signalisation de l'ensemble de la figure 1 ;
- la figure 4 est une vue de la base de ce commutateur d'éclairage, en coupe selon l'axe de la manette de la figure 3, dans un plan vertical par rapport à cette figure ;
- la figure 5 est une vue en coupe selon la ligne V-V de la figure 4 ;
- la figure 6 est une vue en perspective éclatée du commutateur d'essuie-vitre de l'ensemble de la figure 1 ;
- la figure 7 est une vue en perspective de la base du commutateur d'essuie-vitre de la figure 6 ;
- la figure 8 est une vue en coupe dans le plan VIII-VIII de la figure 7 ;
- la figure 9 est une vue en coupe dans le plan IX-IX de la figure 7 ;
- la figure 10 est une vue en coupe dans le plan X-X de la figure 7 ; et
- la figure 11 est une vue en coupe dans le plan XI-XI de la figure 7.

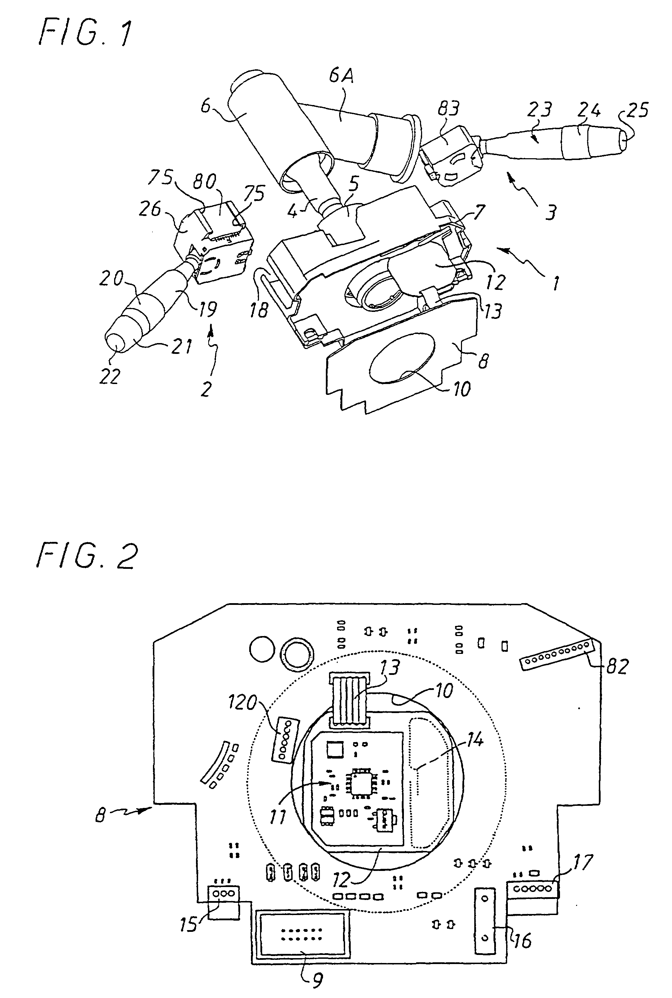

L'ensemble de commutation de la figure 1 comprend d'une manière générale un bloc de support 1 et, montés sur ce bloc de support, un commutateur d'éclairage 2 et un commutateur d'essuie-vitre 3. Le bloc de support 1 est traversé par l'arbre de direction 4 et comporte une douille 5, engagée sur la colonne de direction fixe 6 et fixée à cette dernière par un collier non représenté, en avant du volant. La colonne de direction 6 présente, en arrière du commutateur 3, un tube 6A destiné à recevoir le dispositif antivol.

Le bloc de support 1 est composé pour l'essentiel d'un boîtier 7 dont est solidaire la douille 5, et qui est fermé vers l'arrière (côté conducteur) par un circuit imprimé 8 formant la carte mère de l'ensemble de commutation, fixée par tout moyen convenable. La carte mère 8 est, comme on le verra ci-après, reliée électriquement aux commutateurs d'éclairage 2 et d'essuie-vitre 3. Elle supporte par ailleurs, notamment, un connecteur 9 (figure 2) permettant sa liaison au faisceau électrique du véhicule. On observera ici que les commutateurs 2 et 3 ne commutent que des courants de commande de l'électronique portée par la carte mère 8, donc des courants faibles.

La carte mère 8, figure 2, comporte une découpe 10 circulaire traversée par l'arbre de direction 4. En fait, la carte mère 8 est munie de ses composants avant d'être découpée, et des composants 11 sont montés en particulier sur la partie 12 destinée à être découpée. Cette partie 12 est reliée à sa partie supérieure, également avant découpe, à la partie principale de la carte mère 8, par une nappe de fils 13 assurant la connexion des composants 11.

La partie 12 est ensuite découpée avant le montage de la carte mère 8 sur le bloc de support 1. Lors de ce montage, la partie 12 est elle-même montée sur le bloc de support 1 dans des glissières horizontales, non représentées, au dessus de l'arbre de direction 4.

Les composants 11 montés sur la partie découpée 12 constituent le récepteur radiofréquence de la télécommande d'alarme et de verrouillage des portières du véhicule. Cette partie 12 supporte également l'antenne 14 de ce récepteur, sérigraphiée.

En plus du connecteur 9 précité et des moyens de connexion des commutateurs 2 et 3 qui seront décrits ci-après, la carte mère 8 supporte ici un connecteur 15 pour la commande (non représentée à la figure 1) du récepteur radio, un ronfleur 16 et un connecteur 17 pour un régulateur de vitesse.

Les bases des commutateurs 2 et 3 sont montées à l'intérieur du bloc de support 1 où elles sont fixées par tous moyens convenables. Seules leurs manettes de commande sortent du bloc 1 par des fentes latérales 18.

Extérieurement, la manette de commande du commutateur d'éclairage 2 se compose, d'une part, d'un corps 19, monté rotatif dans un plan parallèle au volant et dans le plan que la manette définit avec la colonne de direction dit plan de la colonne de direction, perpendiculaire au précédent, et, d'autre part, d'une bague rotative médiane 20, d'une bague rotative d'extrémité 21, et d'un bouton poussoir d'extrémité 22.

Dans le plan parallèle au volant, le corps 19 du commutateur 2 possède une position médiane stable avec, de part et d'autre, une position intermédiaire instable et une position d'extrémité stable. La position médiane est neutre, les positions intermédiaires haute et basse correspondent aux clignotants d'autoroute droit et gauche respectivement, et les positions d'extrémité haute et basse correspondent aux clignotants stables droit et gauche.

Dans le plan de la colonne de direction, le corps 19 du commutateur 2 possède une position neutre stable avec, par déplacement vers l'arrière (vers le volant), une première et une deuxième positions instables. La première position instable correspond à l'appel de phares et la deuxième position instable correspond à l'inversion codes/phares.

La bague médiane 20 possède une position neutre stable avec, de part et d'autre, une position instable. Une première impulsion vers la première position instable provoque l'allumage des feux de brouillard avant, et une deuxième impulsion vers cette première position instable provoque en outre l'allumage des feux de brouillard arrière. Une première impulsion vers la deuxième position instable provoque l'extinction des feux de brouillard arrière, et une deuxième impulsion vers cette deuxième position instable provoque l'extinction des feux de brouillard avant.

La bague 21 d'extrémité de manette commande l'éclairage et possède trois positions stables. Une des positions d'extrémité est le neutre (feux éteints), la position médiane sélectionne l'éclairage de ville, et l'autre position d'extrémité sélectionne l'éclairage de route.

Le bouton d'extrémité 22 possède une position stable neutre et, enfoncé, déclenche par exemple l'avertisseur sonore.

La manette du commutateur 3 d'essuie-vitre se compose extérieurement d'un corps de manette 23, rotatif dans un plan parallèle au volant et dans le plan que la manette définit avec la colonne de direction, dit plan de la colonne de direction, d'une bague rotative 24, et d'un bouton poussoir d'extrémité 25.

Dans le plan parallèle au volant, le corps 23 de manette possède une position médiane neutre stable, deux positions instables successives par déplacement vers le bas, deux positions instables successives par déplacement vers le haut et, au delà de ces deux dernières positions, trois positions stables vers le haut. Le déplacement vers le haut vers la première position instable correspond à la mise en fonction de l'essuie-vitre avant par intermittence puis, par impulsions successives, à des vitesses de plus en plus grandes. Le déplacement vers le haut vers la deuxième position instable correspond à la mise en fonction de l'essuie-vitre avant en grande vitesse. La première position stable haute met l'essuie-vitre avant en fonction par intermittence, la deuxième le met en fonction en petite vitesse et la troisième en grande vitesse. Des déplacements successifs vers le bas vers la première position instable entraînent une réduction progressive de la vitesse de fonctionnement de l'essuie-vitre avant, et un déplacement vers le bas vers la deuxième position instable entraîne son arrêt.

Dans le plan de la colonne de direction, le corps 23 du commutateur possède une position neutre stable et une position instable. Le maintien du commutateur en position instable fait fonctionner le lave-vitre avant.

La bague 24 possède deux positions stables et une position instable. Une position stable est la position neutre, et la deuxième position stable est celle de fonctionnement de l'essuie-vitre arrière. Au delà de cette deuxième position stable, la position instable correspond à la mise en fonctionnement du lave-vitre arrière.

L'enfoncement du bouton 25 provoque le défilement des informations de l'ordinateur de bord.

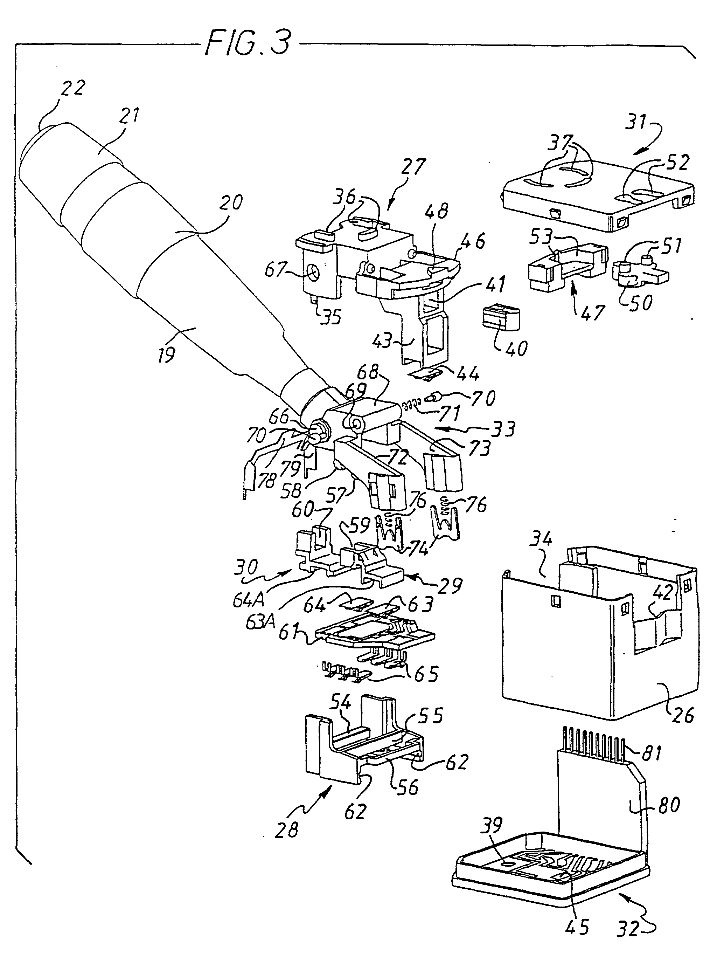

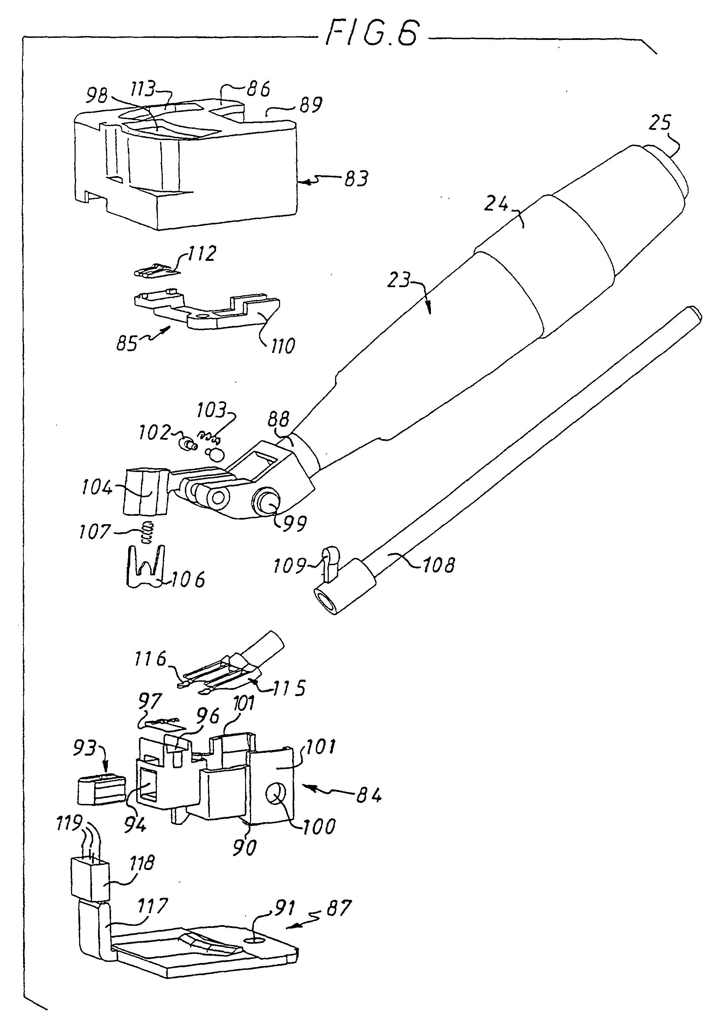

On décrira maintenant en détail la base du commutateur 2 d'éclairage et de signalisation, en référence aux figures 3 à 5. La manette elle-même ne sera pas décrite, étant du type connu ne comportant pas de fil de liaison électrique.

La base du commutateur 2 comprend un boîtier 26 qui contient pour l'essentiel un moyeu 27, un porte-chariots 28, un chariot 29 de sélection d'éclairage route/ville, et un chariot 30 de commande des feux de brouillard. Il est fermé coté volant par un couvercle 31 encliqueté et, coté opposé au volant, par une platine surmoulée 32 emboîtée.

L'extrémité 33 du corps 19 de manette traverse une découpe 34 du boîtier 26 et est engagée dans le moyeu 27.

Le moyeu 27 est monté rotatif dans le boîtier 26 autour d'un axe sensiblement parallèle à l'axe de l'arbre de direction en vue de la commande des clignotants. A cet effet, il possède en partie haute trois bossages 36 en forme de secteurs de cercle engagés dans des fentes 37 de formes correspondantes aménagées dans le couvercle 31. Le porte-chariots 28 est lié en rotation au moyeu 27 grâce à deux pions 35 que comporte le moyeu 27 et qui sont reçus dans deux logements correspondants du porte-chariots 28 ; en variante, cette liaison en rotation peut être obtenue par une complémentarité des formes du moyeu 27 et du porte-chariots 28, l'un s'emboîtant partiellement dans l'autre ; le porte-chariots 28 est muni d'un doigt de pivotement 38 engagé dans un orifice 39 de la platine 32, ce qui conforte le guidage en pivotement de l'ensemble moyeu 27 et porte-chariots 28.

Le pivotement du moyeu 27 et du porte-chariots 28 est commandé par la rotation du corps 19 de manette dans le plan parallèle au volant. Son indexation dans ses trois positions stables est obtenue par un plongeur 40, monté coulissant dans un logement 41 du moyeu 27 et pressé par un ressort non représenté vers des crans 42 formés à la surface intérieure du boîtier en vis à vis de la découpe 34.

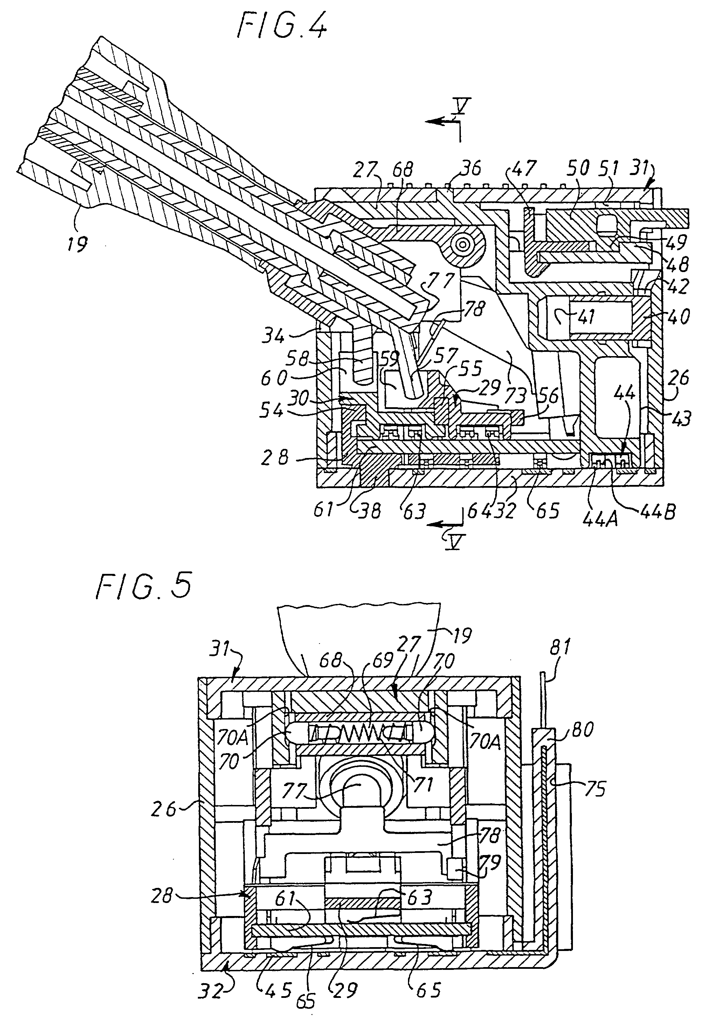

La partie inférieure 43 du moyeu 27 maintient et manoeuvre un curseur 44 qui coopère avec des pistes d'un circuit 45 formé à la surface interne de la platine 32 ; avantageusement, le curseur 44 est double, c'est-à-dire qu'il présente deux têtes de contact 44A, 44B, figure 4, pour assurer la fiabilité du contact électrique : ceci est d'ailleurs vrai également pour les autres curseurs décrits ci-après.

La partie supérieure 46 du moyeu 27 porte un tiroir 47 d'indicateur de direction, agencé pour assurer la fonction de rappel automatique de la manette de clignotant d'une position indexée à sa position centrale pour une rotation du volant dans le sens inverse de la direction indiquée.

A cet effet, la face supérieure du moyeu 27 forme une came 48 en V, constituant des rampes, sur laquelle vient s'appuyer et coulisser un tourillon 49 (figure 4) porté par un doigt de rappel 50. Dans la position neutre de la manette, le tourillon 49 se trouve sur l'arête de la came 48, sur laquelle il est plaqué par un ressort non représenté. Lorsque la manette est actionnée vers une de ses positions indexées, le tourillon 49 glisse sur une des rampes de la came 48 et le doigt de rappel 50 sort en direction de l'axe de la colonne de direction, comme montré à la figure 4.

Le doigt 50 porte par ailleurs deux pivots supérieurs 51 engagés dans des rainures 52 du couvercle 31. Lors de la rotation du volant en sens inverse de la direction indiquée, un organe de rappel porté par l'arbre de direction vient en contact avec l'extrémité sortie du doigt de rappel 50. L'effort appliqué fait pivoter le doigt de rappel 50, dont la partie arrière vient s'appuyer sur les pentes latérales 53 du tiroir 47. Le couple alors créé entre les pivots supérieurs 51, calés dans les rainures 52, et les pentes 53 du tiroir 47, fait sortir le plongeur 40 de son cran 42 d'indexage et la manette du commutateur 2 revient à sa position centrale.

Si la manette est maintenue volontairement à sa position indexée alors que le volant est ramené en sens inverse de la direction indiquée, des ressorts non représentés, situés derrière le tiroir 47, fléchissent de sorte que le tiroir 47 recule en permettant ainsi le passage de l'organe de rappel de l'arbre de direction, toute dégradation étant ainsi évitée.

Le porte-chariots 28 supporte les chariots 29 et 30 de façon coulissante verticalement parallèlement à la platine 32, c'est-à-dire globalement verticalement lorsque le commutateur est monté sur le véhicule. A cet effet, il possède trois barres de guidage parallèles, deux barres de guidage d'extrémité 54 et 56 et une barre de guidage intermédiaire 55 ; chacun des chariots 29 et 30 coopère en guidage avec une barre de guidage d'extrémité et la barre de guidage intermédiaire, et son guidage est ainsi parfaitement assuré ; ici, le chariot 29 coopère avec la barre de guidage d'extrémité 56 et la barre de guidage intermédiaire 55, et le chariot 30 avec cette même barre de guidage intermédiaire 55 et la barre de guidage d'extrémité 54.

Les chariots 29 et 30 sont mus sur le porte-chariots 28 par des doigts 57 et 58, engagés dans des logements 59 et 60 des chariots et commandés respectivement par les bagues 21 et 20 de la manette.

Le porte-chariots 28 supporte par ailleurs un circuit imprimé de sélection 61, dans deux glissières 62 situées sous les barres 54, 55 et 56, parallèlement à la platine 32. Les pistes de ce circuit imprimé 61 coopèrent avec deux curseurs de sélection 63 et 64. Le curseur 63 est maintenu dans un logement 63A que présente le chariot 29 de sélection route/ville et est manoeuvré par celui-ci ; le curseur 64 est maintenu dans un logement 64A que présente le chariot 30 de feux de brouillard et est manoeuvré par celui-ci. La liaison électrique entre le circuit imprimé de sélection 61 et le circuit 45 de la platine 32 est assurée par des curseurs de liaison 65 soudés sur la face inférieure du circuit imprimé de sélection 61.

Cet agencement, comprenant le circuit imprimé de sélection 61 solidaire du porte-chariots 28 et du moyeu 27, et les curseurs de liaison 65 entre le circuit imprimé de sélection 61 et le circuit 45, évite de perturber le positionnement des chariots 29 et 30 sur les pistes du circuit imprimé de sélection 61 lors de la mise en fonction des clignotants.

Le corps 19 de manette est muni de deux pivots 66 d'axe vertical engagés dans des trous 67 du moyeu 27. La manette peut ainsi pivoter dans le plan de la colonne de direction pour assurer les fonctions d'appel de phares et d'inversion codes/phares. L'extrémité du corps 19 de manette possède par ailleurs, au delà des pivots 66, un prolongement 68 dans lequel un perçage 69 reçoit deux plongeurs 70 tenus écartés l'un de l'autre par un ressort 71. Les plongeurs 70 coopèrent avec des pentes 70A prévues sur le moyeu 27 pour fournir les deux courses successives assurant les deux fonctions ci-dessus.

L'extrémité du corps 19 de manette se termine par deux bras 72 et 73. Chaque bras 72, 73 porte un curseur 74. Ces deux curseurs 74 sont pressés vers le bas par des ressorts 76, en direction des pistes du circuit 45. Les deux bras 72 et 73 sont décalés en hauteur de manière que les curseurs 74 entrent successivement en contact avec leurs pistes respectives pour assurer d'abord la fonction d'appel de phares après la première course, puis la fonction d'inversion codes/phares après la deuxième course. La mémorisation des fonctions est assurée par l'électronique.

Le bouton poussoir 22 en bout de manette est solidaire d'un doigt 77, figure 4, d'actionnement d'avertisseur sonore. Le doigt 77 est en vis-à-vis d'une lame de contact 78 susceptible de fléchir sous sa poussée. Dans ce cas, la lame 78 vient contacter une sortie de lame 79 en assurant la continuité électrique.

La lame 78 et la sortie de lame 79 sont liées électriquement au circuit imprimé de sélection 61 et donc supportées par le porte-chariots 28. La fonction d'avertisseur n'est donc pas perturbée lors de l'utilisation des clignotants.

La platine 32 est solidaire d'un rabat 80 à 90° portant à son extrémité des broches de connexion 81 reliées électriquement aux pistes du circuit 45. Le rabat 80 prend place dans des glissières 75, mieux visibles sur la figure 1, que présente le boîtier 26 sur sa face latérale correspondante ; lorsque le commutateur est en place, le rabat 80 est en position haute et les broches 81 sont engagées dans un connecteur 82 porté par la carte mère 8.

Le fonctionnement du commutateur 2 d'éclairage et de signalisation résulte de la description qui vient d'en être faite ; on rappellera simplement que l'agencement est tel que les fonctions réalisées par rotation du corps 19 de manette dans le plan parallèle au volant ne risquent pas de perturber les autres fonctions grâce à la liaison en rotation du moyeu 27 et du porte-chariots 28, lesquels sont montés à pivotement sur le boîtier 26, le porte-chariots 28 par l'intermédiaire de la platine 32 et le moyeu 27 par l'intermédiaire du couvercle 31.

On décrira maintenant la base du commutateur 3 d'essuie-vitre en référence aux figures 6 à 11. Ici non plus, on ne décrira pas la manette elle-même du commutateur, qui est de type connu.

La base du commutateur 3 comprend un boîtier 83 qui contient essentiellement un moyeu 84 et une biellette 85 d'essuie-vitre arrière. Le boîtier 83 est partiellement fermé coté volant par un dessus 86 réalisé d'une seule pièce avec lui et, du coté opposé, par une platine surmoulée 87 emboîtée. L'extrémité 88 du corps 23 de manette traverse une découpe 89 du boîtier et est engagée dans le moyeu 84.

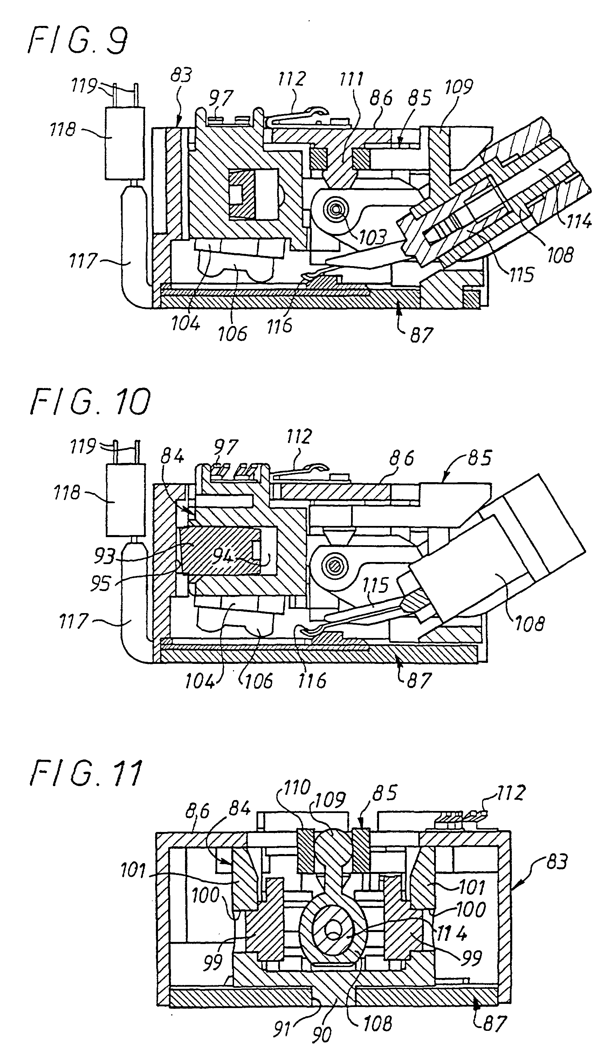

Le moyeu 84 est monté pivotant dans le boîtier 83, autour d'un axe parallèle à l'axe de la colonne de direction, en vue de la commande de l'essuie-vitre avant. A cet effet, il est muni en partie basse d'un tourillon 90 engagé dans un trou 91 formé dans la platine 87, figure 11 ; par ailleurs, le moyeu 84 présente latéralement des ailes 101 bordées extérieurement par une face en secteur cylindrique, à section circulaire centrée sur l'axe du tourillon 90 et du trou 91, qui coopère avec une face complémentaire 92 ménagée à l'intérieur du boîtier 83 : ainsi, le pivotement du moyeu 84 dans le boîtier 83 est parfaitement assuré.

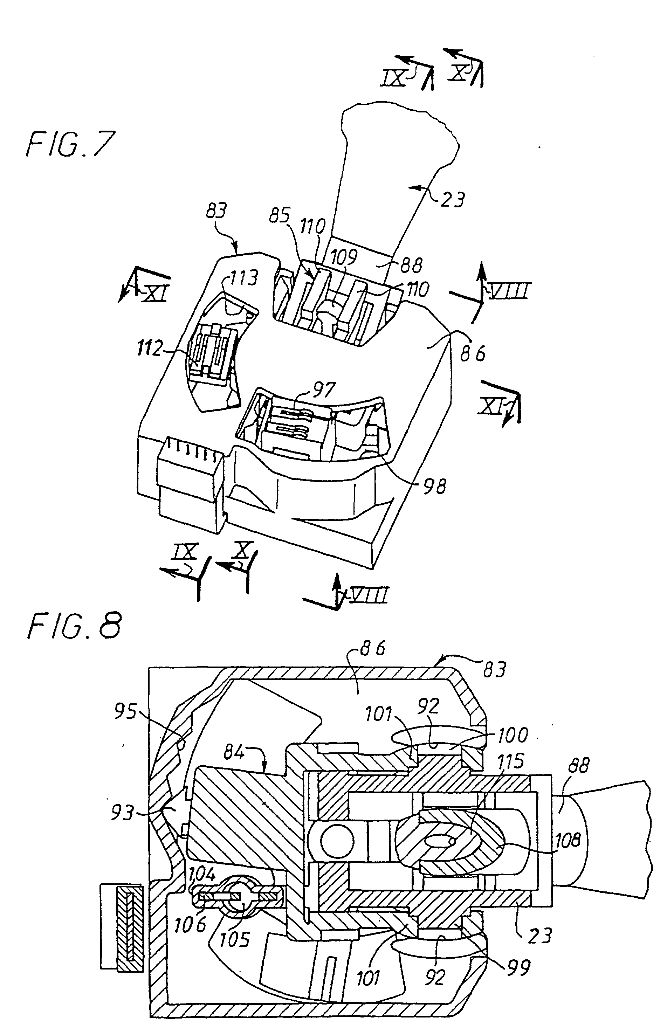

Le pivotement du moyeu 84 est commandé par la rotation du corps 23 de manette dans le plan parallèle au volant. Son indexation dans ses quatre positions stables est obtenue par un plongeur 93, disposé dans un logement 94 du moyeu 84 et pressé par un ressort non représenté en direction de crans d'indexation 95, figure 8, formés à la surface intérieure du boîtier 83.

La face supérieure du moyeu 84 comporte un logement 96 pour maintenir et manoeuvrer un contact 97. Le contact 97 coopère avec dès pistes directement tracées sur la carte mère 8. A cet effet, le dessus 86 du moyeu 84 comporte une première fenêtre 98 découpée en vis-à-vis du trajet de déplacement du contact 97, lequel fait saillie à l'extérieur du boîtier 83.

L'extrémité du corps 23 de manette porte deux tourillons 99 engagés dans des trous de pivotement 100 formés dans les ailes 101 du moyeu 84. Il est ainsi susceptible de pivoter vers l'arrière dans le plan de la colonne de direction en vue de la commande du lave-vitre avant. Son indexation dans ce mouvement est réalisée par deux plongeurs 102, logés dans des trous formés à l'extrémité du corps 23 de manette et maintenus écartés par un ressort 103. Ces plongeurs 102 coopèrent avec des rampes formées à la surface intérieure du moyeu 84.

Un prolongement 104 de l'extrémité du corps 23 de manette forme un logement 105 pour un curseur 106 et son ressort 107, figures 6 et 7. Lorsque la manette du commutateur 3 est manoeuvrée vers l'arrière dans le plan de la colonne de direction, elle pivote donc autour des tourillons 99 de sorte que le curseur 106 vient shunter deux pistes sur la platine surmoulée 87, faisant ainsi fonctionner le lave-vitre avant, et ceci quelle que soit la position de la manette pour les fonctions de l'essuie-vitre avant.

Un autre curseur opposé au curseur 106 pourrait coopérer avec des pistes formées sur la carte mère 8 pour actionner un lave-vitre arrière par une manoeuvre de la manette vers l'avant.

La bague 24 de la manette est solidaire en rotation d'une tige 108 creuse qui pivote dans le corps 23 de manette. La tige 108 porte à son extrémité un doigt 109 de commande de l'essuie-vitre arrière. Le doigt 109 est disposé entre deux ailes 110 de la biellette 85. Cette biellette 85 est montée en rotation autour d'un pivot 111 issu du dessus 86 du boîtier 83 et perpendiculaire audit dessus 86.

Plus précisément, la biellette 85 comporte deux bras se raccordant sensiblement perpendiculairement au niveau de son axe de rotation. L'un dès bras porte les deux ailes 110 de la biellette 85 et l'autre bras supporte et manoeuvre un contact d'essuie-vitre arrière 112. Le contact 112 coopère directement avec des pistes de la carte mère 8, en faisant saillie à l'extérieur du boîtier 83 à travers une deuxième fenêtre 113 découpée dans le dessus 86 du boîtier 83. L'amplification de mouvement créée par la biellette 85 permet d'obtenir l'écartement voulu entre les zones de contact sur la carte mère 8.

Le bouton poussoir 25 est solidaire axialement d'une tige 114 montée coulissante dans le corps 23 de manette, plus précisément à l'intérieur de la tige 108. Un poussoir 115 est emmanché à l'extrémité de cette tige 114, et porte une lame de contact 116 à deux bras. Lors de l'enfoncement du bouton poussoir 25, la lame 116 vient contacter des pistes formées à la surface de la platine surmoulée 87 et provoquer le défilement des informations affichées par l'ordinateur de bord.

La platine 87 est solidaire d'un rabat 117 à 90° portant à son extrémité un connecteur 118 à broches 119. Les broches 119 sont électriquement reliées aux pistes de la platine 87. Lorsque le commutateur 3 est monté sur le bloc de support 1, le connecteur 118 s'engage dans un connecteur 120 monté sur la carte mère 8, visible sur la figure 1, assurant ainsi la liaison à cette dernière des pistes de la platine 87.

Le fonctionnement du commutateur 3 d'essuie-vitre résulte de la description qui vient d'en être faite ; on rappellera simplement que l'agencement est tel que les fonctions réalisées par rotation du corps 23 de manette dans le plan parallèle au volant ne risquent pas de perturber les fonctions réalisées par rotation du corps 23 de manette dans le plan de la colonne de direction : en effet, les premières mettent en oeuvre des organes, biellette 85 et moyeu 84, portés par le boîtier 83 sur lequel ils sont montés tournant, tandis que les secondes mettent en oeuvre des organes portés par l'extrémité 88 du corps 23 de manette monté articulé sur le moyeu 84 autour d'un axe orthogonal par rapport à celui du moyeu 84.

On a décrit, ci-dessus, un commutateur 2 d'éclairage et signalisation et un commutateur d'essuie-vitre 3 ; bien entendu, tout ou partie des caractéristiques décrites à propos du commutateur 2 d'éclairage et signalisation pourraient être utilisées pour la réalisation d'un commutateur d'essuie-vitre ; de même, tout ou partie des caractéristiques décrites à propos du commutateur d'essuie-vitre 3 pourraient être utilisées pour la réalisation d'un commutateur d'éclairage et signalisation.

On appréciera que le boîtier 83 du commutateur d'essui-vitre 3 est fermé par une seule pièce, à savoir la platine surmoulée 87. Ainsi qu'il ressort à l'évidence de la description et des dessins, les rabats 117, 80 des platines 87, 32 permettent une réduction de l'encombrement parallèlement à la colonne de direction 6. La localisation de l'antenne 14 est favorable puisqu'elle est localisée dans la partie haute du bloc support 1, au dessus de l'arbre de direction 4, en sorte que la réception est bonne, sachant que le bloc support 1 est en matière plastique moulable et électriquement isolante.

Il en est de même de la majeure partie des pièces des commutateurs 2 et 3, à l'exception des curseurs, des pistes électriques, des ressorts, des broches, et de toute autre partie électriquement conductrice.

Tout cela est bien connu, la technique de moulage étant économique et permettant d'obtenir des formes compliquées.

Ainsi, les boîtiers 26, 83, les corps de manettes 19, 23, les moyeux 27, 84, les platines 32, 87, les plongeurs, les chariots 29, 30, le porte chariot 28, le tiroir 47, le doigt 50, la biellette 85, les rabats 80, 117, les bras 42, 73 et les prolongements 68, 104 sont en matière plastique moulable et électriquement isolante.

On notera que les chariots 29, 30 comportent des rainures (non référencées) pour leur montage sur les barrettes 54, 55.

## Revendications

1. Ensemble de commutation de haut de colonne de direction de véhicule automobile comprenant un boîtier (7), monté sur la colonne de direction (6) pour supporter, au-dessus de ladite colonne, un récepteur radiofréquence (11, 14) de télécommande et son antenne (14), l'ensemble comprenant une carte de circuit imprimé formant carte mère (8), traversée par la colonne de direction (6), électriquement connectée à une partie (12) de circuit imprimé, portée par le boîtier (7), sur laquelle sont montés des composants (11) constituant le récepteur radiofréquence, ladite carte mère (8) portant un connecteur (9) de liaison au faisceau électrique du véhicule.

2. Ensemble de commutation selon la revendication 1, **caractérisé par le fait que** ladite partie (12) de circuit imprimé est formée dans la partie de la carte mère (8) découpée (10) pour le passage de la colonne de direction (6) et électriquement reliée à la carte mère (8) par une nappe de fils (13).

3. Ensemble de commutation selon la revendication 2, **caractérisé par le fait que** la découpe (10) est circulaire.

4. Ensemble de commutation selon l'une des revendications 1 à 3, **caractérisé par le fait que** ladite partie (12) de circuit imprimé est engagée dans des glissières du boîtier (7).

5. Ensemble de commutation selon l'une des revendications 1 à 4, **caractérisé par le fait que** l'antenne (14) est sérigraphiée sur la partie (12) de circuit imprimé.

6. Ensemble de commutation selon l'une des revendications 1 à 5, **caractérisé par le fait que** le boîtier (7) supporte au moins un commutateur (2, 3) coopérant électriquement avec la carte mère (8).

7. Ensemble de commutation selon la revendication 6, **caractérisé par le fait que** le commutateur est un commutateur (2) d'éclairage et signalisation.

8. Ensemble de commutation selon la revendication 6, **caractérisé par le fait que** le commutateur est un commutateur (3) d'essuie-vitre et lave-vitre.

9. Ensemble de commutation selon l'une des revendications 1 à 8, **caractérisé par le fait que** la télécommande commande une alarme et/ou le verrouillage-déverrouillage des ouvrants et/ou de l'allumage et/ou de l'alimentation en carburant.

10. Procédé de réalisation d'un ensemble de commutation selon l'une des revendications 2 à 9, **caractérisé par le fait que** l'on monte les composants sur un circuit imprimé unique, avec la nappe de fils reliant la partie centrale de ce circuit imprimé unique formant la partie de circuit imprimé à sa partie périphérique formant carte mère, et que l'on découpe ensuite la partie centrale.

## Claims

1. Upper steering column switching apparatus for a motor vehicle, comprising a casing (7) mounted on the steering column (6) for supporting, above the said column, a radio frequency remote-control receiver (11, 14) and its antenna (14), the apparatus including a printed circuit board defining a mother board (8) through which the steering column (6) extends and which is connected electrically to a printed circuit part (12) carried by the casing (7), and on which there are mounted components (11) constituting the radio frequency receiver, the said mother board (8) carrying a connector (9) for connection to the electrical network of the vehicle.

2. Switching apparatus according to Claim 1, **characterised by** the fact that the said printed circuit part (12) is formed in the part (10) of the mother board (8) which is cut out for passage of the steering column (6) through it, and is connected electrically to the mother board (8) through a bundle of wires (13).

3. Switching apparatus according to Claim 2, **characterised by** the fact that the cut-out (10) is circular.

4. Switching apparatus according to one of Claims 1 to 3, **characterised by** the fact that the said printed circuit part (12) is engaged in slides of the casing (7).

5. Switching apparatus according to one of Claims 1 to 4, **characterised by** the fact that the antenna (14) is printed on the printed circuit part (12) by screen process printing.

6. Switching apparatus according to one of Claims 1 to 5, **characterised by** the fact that the casing (7) supports at least one switch (2, 3) which is in electrical cooperation with the mother board (8).

7. Switching apparatus according to Claim 6, **characterised by** the fact that the switch is a lighting and indicator switch (2).

8. Switching apparatus according to Claim 6, **characterised by** the fact that the switch is a screen wiper and screen washer switch (3).

9. Switching apparatus according to one of Claims 1 to 8, **characterised by** the fact that the remote controller controls an alarm, and/or the locking/unlocking of the access openings and/or of the ignition and/or of the fuel supply.

10. A method of making a switching apparatus according to one of Claims 2 to 9, **characterised by** the fact that the components are mounted on a single printed circuit, with the bundle of wires connecting the central part of the single printed circuit, constituting the said printed circuit part, to its peripheral part which constitutes the mother board, and in that the central part is subsequently cut out.

## Patentansprüche

1. Schalteranordnung am Lenksäulenoberteil eines Kraftfahrzeugs mit einem Gehäuse (7), das an der Lenksäule (6) angebracht ist, um oberhalb der besagten Lenksäule einen Hochfrequenzempfänger (11, 14) für eine Fernbetätigung und seine Antenne (14) zu lagern, wobei die Schalteranordnung eine als Mutterplatine (8) dienende Leiterplatte trägt, durch die die Lenksäule (6) hindurchgeht und die an einen am Gehäuse (7) angebrachten gedruckten Schaltungsteil (11) elektrisch angeschlossen ist, an welchem den Hochfrequenzempfänger bildende Bauelemente (11) angebracht sind, wobei die besagte Mutterplatine (8) einen Verbinder (9) zum Anschluß an den elektrischen Kabelstrang des Fahrzeugs trägt.

2. Schalteranordnung nach Anspruch 1, **dadurch gekennzeichnet, daß** der besagte gedruckte Schaltungsteil (12) in dem Teil der Mutterplatine (8) ausgebildet ist, der für den Durchgang der Lenksäule (6) ausgestanzt und mit der Mutterplatine (8) durch ein Flachkabel (13) elektrisch verbunden ist.

3. Schalteranordnung nach Anspruch 2, **dadurch gekennzeichnet, daß** die Ausstanzung (10) kreisförmig ausgeführt ist.

4. Schalteranordnung nach einem der Ansprüche 1 bis 3, **dadurch gekennzeichnet, daß** der besagte gedruckte Schaltungsteil (12) in Gleitführungen des Gehäuses (7) eingesetzt ist.

5. Schalteranordnung nach einem der Ansprüche 1 bis 4, **dadurch gekennzeichnet, daß** die Antenne (14) durch Siebdruck auf dem gedruckten Schaltungsteil (12) ausgeführt ist.

6. Schalteranordnung nach einem der Ansprüche 1 bis 5, **dadurch gekennzeichnet, daß** das Gehäuse (7) wenigstens einen Schalter (2, 3) enthält, der mit der Mutterplatine (8) elektrisch zusammenwirkt.

7. Schalteranordnung nach Anspruch 6, **dadurch gekennzeichnet, daß** es sich bei dem Schalter um einen Schalter (2) für die Beleuchtungs- und Signalanlage handelt.

8. Schalteranordnung nach Anspruch 6, **dadurch gekennzeichnet, daß** es sich bei dem Schalter sich um einen Schalter (3) für die Scheibenwisch- und Scheibenwaschanlage handelt.

9. Schalteranordnung nach einem der Ansprüche 1 bis 8, **dadurch gekennzeichnet, daß** die Fernbetätigung eine Alarmanlage und/oder die Verriegelung/Entriegelung der Öffnungsvorrichtungen und/ oder die Zündanlage und/oder die Kraftstoffzufuhr steuert.

10. Verfahren zur Herstellung einer Schalteranordnung nach einem der Ansprüche 2 bis 9, **dadurch gekennzeichnet, daß** die Bauelemente auf einer einzigen gedruckten Schaltung angebracht werden, wobei das Flachkabel den Mittelteil dieser einzigen gedruckten Schaltung, die den gedruckten Schaltungsteil bildet, mit ihrem die Mutterplatine bildenden Umfangsteil verbindet, und daß anschließend der Mittelteil ausgestanzt wird.
